# EUROPEAN PATENT SPECIFICATION

(11) **EP 0 445 880 B1**
(45) Date of publication and mention of the grant of the patent: **11.10.1995**
(21) Application number: 91200450.4
(22) Date of filing: 04.03.1991
(51) Int. Cl.: G11C 7/00

(54) **Write-acknowledge circuit comprising a write detector and a bistable element for four-phase handshake signalling**
Schreiberkennungsschaltung mit einem Schreibdetektor und einem bistabilen Element für Vier-Phasen-Quittungssignalisierung
Circuit de reconnaissance d'écriture comportant un détecteur d'écriture et un élément bistable pour signaler des accusés de réception à quatre phases

(30) Priority: 09.03.1990 NL 9000544
(43) Date of publication of application: 11.09.1991
(73) Proprietor: Philips Electronics N.V., 5621 BA Eindhoven (NL)
(72) Inventor: Van Berkel, Cornelis Hermanus, NL-5656 AA Eindhoven (NL); Saeijs, Ronald Wilhelm Johan Jozef, NL-5656 AA Eindhoven (NL)
(74) Representative: Strijland, Wilfred

(56) References cited:
- EP-A- 0 179 651
- EP-A- 0 250 242
- EP-A- 0 337 172
- US-A- 4 563 599
- IEEE JOURNAL OF SOLID-STATE CIRCUITS. vol. SC-20, no. 5, October 1985, NEW YORK US pages 941 - 945; LAL C.SOOD ET AL: "A FAST 8Kx8 CMOS SRAM WITH INTERNAL POWER DOWN DESIGN TECHNIQUES"
- IBM TECHNICAL DISCLOSURE BULLETIN. vol. 27, no. 10B, March 1985, NEW YORK US pages 6189 - 6191; "STATIC RAM INPUT BUFFER AND ITS TRANSITION DETECTOR"

## Description

The invention relates to a write-acknowledge circuit comprising a write detector having two write inputs, two complementary inputs and an acknowledge output and including a bistable element having two inputs which form the two respective write inputs of the write detector and having two outputs coupled crosswise to the complementary inputs of the write detector for applying two complementary signals to the two complementary inputs of the write detector in response to a write signal on one of the two write inputs.

A write-acknowledge circuit of this type is known from European Patent Specification No. 0 329 233 (PHQ 88.005). The Boolean value of a single variable is applied to both write inputs of the write-acknowledge circuit: to one write input the value "TRUE" and to the other write input the value "FALSE" is applied. This is also termed Double-Rail Encoding.

Producing an acknowledge signal in response to a write signal on a write input renders this write-acknowledge circuit extremely suitable for use in delay-insensitive circuits which operate at any combination of delays of individual gates and connections. In delay-insensitive circuits communication takes place by means of changes in the signal values on the wires between the inputs and outputs (for example, the write inputs and acknowledge output of the write-acknowledge circuit). The delay-insensitivity is caused by the fixed-causality relations between the signal changes.

The disadvantage of Double-Rail Encoding is that two wires instead of one are used for transmitting the two signal values of a 1-bit variable. The use of two wires, however, is advantageous in that it is a matter of implicit reference, that is to say, the voltage on one wire is high relative to the voltage on the other wire and in this manner the signal value of the variable is determined unambiguously. When using one wire there is no reference point and, consequently, voltage variations on the wire may affect the signal value of the variable. Voltage variations may naturally also occur with Double-Rail Encoding, but since they then occur on the two wires at the same time, voltage variations have no or not a great impact on the implicit reference between the voltages on the two wires.

In the case of Double-Rail Encoding the write-acknowledge circuit does not depend on the clock frequency, as a result of which it is possible for the circuit to operate at a higher speed than if the circuit would actually depend on the clock rate. It should further be observed that the use of two wires does cost space, it is true, but that circuits, components and wires necessary for driving with a clock rate are no longer necessary. On the whole this may have a space saving effect.

Depending on which write input has the logic value "1", the variable has the Boolean value TRUE or FALSE. During the state of rest the write signals on the write inputs have the same logic value (for example, "0"). When either one of the two write signals changes from the state of rest of value "0" to the logic value "1", the acknowledge signal on the acknowledge output will also change from "0" to "1". The acknowledge signal denotes that the write signal has been processed by the circuit and the write signal may again assume the previous value. The acknowledge signal further denotes that a change has occurred in one of the write signals, but gives no information on the write input concerned. Subsequently, the state of rest is reverted to, resulting in the fact that the acknowledge signal also obtains the original logic value.

The above-described procedure is valid for the two write signals and is termed four-phase handshake signalling.

The present embodiment of the write detector in the prior-art write-acknowledge circuit can be arranged comprising 10 transistors. It is an object of the invention to provide a write detector comprising less than 10 transistors.

The write-acknowledge circuit according to the invention is characterized in that the write detector comprises a series connection of two switch elements in which each switch element has a first terminal, a second terminal and a control input, which first terminals form the two write inputs of the write detector, which second terminals are interconnected and collectively form the acknowledge output and in which the control inputs form the two complementary inputs of the write detector.

The inventive understanding is based on the fact that the write signals never have the inverted state of rest values simultaneously. The understanding is likewise based on the fact that the output signals of the bistable element are complementary, so that the switch elements are not conductive simultaneously. Each switch element, for example, is realised by means of a transistor.

An embodiment of the write-acknowledge circuit according to the invention is characterized in that each switch element comprises either an n-MOS transistor having a control input which forms the control input of the switch element or comprises a p-MOS transistor with an inverter where the inverter input forms the control input of the switch element and the inverter output is connected to a control input of the p-MOS transistor, and in that the bistable element comprises two NOR gates having each two inputs and a single output which form the inputs and the outputs of the bistable element.

When the write-acknowledge circuit changes from the state of rest to a different state the output signals of the bistable element may simultaneously have the same logic value, i.e. "0", during this brief transition period. Due to this logic value "0" the two transistors will not be conductive and neither will direct current begin to flow so that there is no chance of the circuit being damaged.

An embodiment of the write-acknowledge circuit may also be characterized in that each switch element comprises either a p-MOS transistor having a control input which forms the control input of the switch element or comprises an n-MOS transistor with an inverter where the inverter input forms the control input of the switch element and the inverter output is connected to a control input of the n-MOS transistor, and in that the bistable element comprises two NAND gates having each two inputs and an output which form the inputs and the outputs of the bistable element.

In this case the output signals of the bistable element may simultaneously have the logic value "1" during the transition period. Even now no direct current will flow since the transistors are not conductive.

The write-acknowledge circuit according to the invention is advantageous in that the circuit requires less space and in that the transmission of the signals by the circuit is faster than by the prior-art circuit.

The invention and its advantages will now be further explained in the description with reference to the appended drawings, in which:
Fig. 1 shows a diagram of an embodiment of a write-acknowledge circuit comprising a write detector and a prior-art bistable element;
Fig. 2 shows an embodiment of the write detector as shown in Fig. 1 at transistor level;
Fig. 3 shows a first embodiment of the write-acknowledge circuit according to the invention;
Fig. 4 shows a second embodiment of the write-acknowledge circuit according to the invention;
Fig. 5 shows a third embodiment of the write-acknowledge circuit according to the invention;
Fig. 6 shows a fourth embodiment of the write-acknowledge circuit according to the invention.

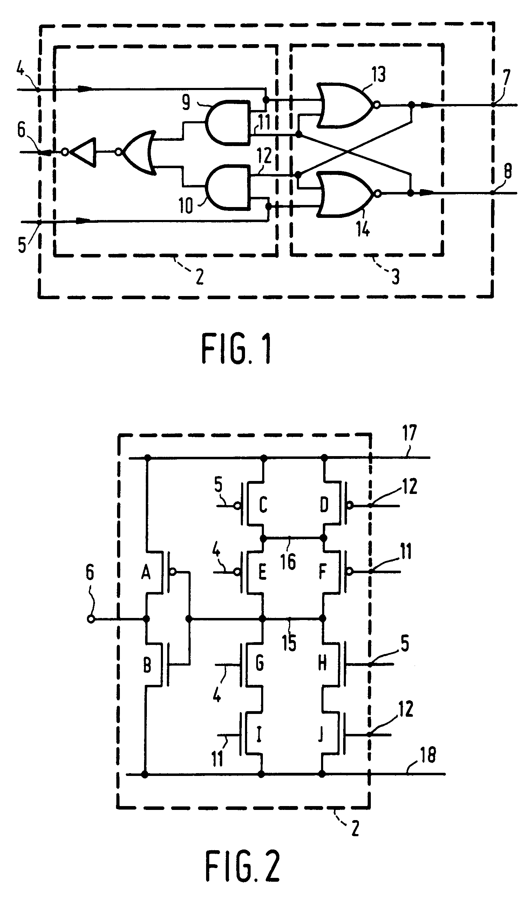

Fig. 1 shows a diagram of a prior-art write-acknowledge circuit 1. The write-acknowledge circuit 1 comprises a write detector 2 and a bistable element 3 connected to one another. The write detector 2 has two write inputs 4 and 5, two complementary inputs 11 and 12 and an acknowledge output 6. The write detector 2 comprises two AND gates 9 and 10 connected to the acknowledge output 6 by means of a NOR gate and an inverter. The AND gates 9 and 10 have each two inputs that form the write inputs 4, 5 and the complementary inputs 11, 12 of the write detector 2.

The bistable element 3 has two NOR gates 13 and 14, having each a first and a second input and outputs 7 and 8 respectively. The outputs 7 and 8 are connected crosswise to the respective second inputs of NOR gates 14 and 13 and the respective complementary inputs 12 and 11 of AND gates 10 and 9. The write inputs 4 and 5 are connected to the first inputs of NOR gates 13 and 14 respectively.

This write-acknowledge circuit 1 is suitable for the application of the four-phase handshake signalling. The signal behaviour of the signals w0, w1 and wa on the respective write inputs 4 and 5 and the acknowledge output 6 is expressed by means of the following expression in which q0 and q1 are the respective output signals on outputs 7 and 8.$\text{{([w0]; q0↓, q1↑; [¬q0 o q1]; wa↑; [¬w0]; wa↓)| ([w1]; q0↑, q1↓; [q0 o ¬q1]; wa↑; [¬w1]; wa↓)} *}$
The following values will be assumed for the initial state of the write-acknowledge circuit 1:$\text{w0 : = FALSE, w1 : = FALSE, wa : = FALSE (q0 o ¬q1) + (¬q0 o q1).}$
In the previous and subsequent expressions "FALSE" is associated with a low voltage and "TRUE" with a high voltage. Furthermore, for these expressions the following will hold:
- ¬a stands for: : the inverted value for variable a
- a↓: : variable obtains the value "FALSE;
- a↑: : variable obtains the value "TRUE"
- [e]: : wait until the Boolean expression e is "TRUE";
- S*: : carry out S for an unlimited number of times;
- S|T: : carry out either S or T;
- S;T: : first carry out S then T;
- a,b: : carry out elementary orders a and b in any order or in parallel;
- o: : AND function;
- +: : OR function.

The write signals w0 and w1 encode a 1-bit variable with this four-phase handshake signalling where, for example, w0 denotes whether the variable has the value "TRUE" and w1 denotes whether the variable has the value "FALSE". This is also termed Double-Rail Encoding. In the initial state, also termed state of rest, the two signals w0 and w1 are "FALSE". Furthermore, both write signals w0 and w1 "TRUE" are excluded from this embodiment of four-phase handshake signalling. The acknowledge signal wa provides an acknowledgement that a change in either one of the two write signals w0 or w1 has been processed by the circuit 1. If a transmitter (not shown) has produced the write signal w0 "TRUE", the transmitter is informed by means of the "TRUE" state of the acknowledge signal wa that the change in the signal value of w0 has been processed by the circuit 1 and that the transmitter may render the write signal w0 "FALSE" again.

Fig. 2 shows an embodiment of the write detector 2 shown in Fig. 1 at transistor level. The write detector 2 comprises a series connection of a p-MOS transistor A and an n-MOS transistor B connected between the voltage points 17 and 18, two parallel-connected p-MOS transistors C and D between the voltage point 17 and a junction 16, two parallel-connected p-MOS transistors E and F between the junctions 16 and 15, and two parallel-connected series arrangements of n-MOS transistors, G and I parallel to H and J, between the junction 15 and voltage point 18. Respective voltages +5 V and 0 V are applied to the voltage points 17 and 18. The voltages represent the logic signals "1" and "0".

The junction of the control inputs of the p-MOStransistor A and n-MOS transistor B is connected to junction 15. The transistors A and B have each a control input connected to one another and which together form the input 15. The series arrangement operates as an inverter inverting the applied logic signal at junction 15 and supplying this inverted logic signal at acknowledge output 6. Furthermore, the control inputs of the p-MOS transistors C and D are connected to write input 5 and output 12. The control inputs of the p-MOS transistors E and F are connected to write input 4 and output 11. The write input 4 and output 11 are likewise connected to the control inputs of the two n-MOS transistors G and I. The control inputs of n-MOS transistors H and J are connected to write input 5 and output 12.

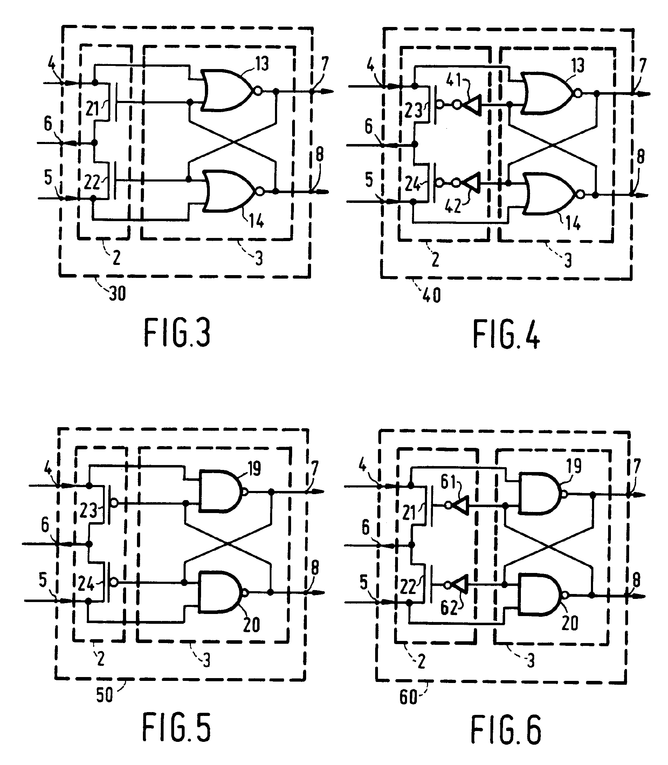

The embodiment of the write detector 2 represented in Fig. 2 comprises 10 transistors. Fig. 3 shows an exemplary embodiment of the write-acknowledge circuit 1 according to the invention in which the write detector 2 comprises no more than two transistors 21 and 22. In addition to the write detector 2 the write-recongition circuit 1 also includes the bistable element 3 arranged in accordance with the bistable element shown in Fig. 1. These two transistors 21 and 22 are arranged in n-MOS technology and connected in series while the connection point of the two n-MOS transistors 21 and 22 is connected to acknowledge output 6. The two n-MOS transistors 21 and 22 have each terminal connected to the respective first inputs of NOR gates 13 and 14, and form the write inputs 4 and 5 respectively. The control inputs of the two n-MOS transistors 21 and 22 are connected to the second inputs of NOR gates 13 and 14 respectively. The control inputs of the transistors 21 and 22 form the complementary inputs of the write detector 2.

The write-acknowledge circuit 30 according to the invention shown in Fig. 3 is also suitable for four-phase handshake signalling. Write detector 2 now includes no more than two transistors because of the fact that with the four-phase handshake signalling the write signals w0 and w1 on write inputs 4 and 5 in Fig. 3 never have the value "1" at the same time and the output signals on outputs 7 and 8 never have the value "1" at the same time.

Fig. 4 shows an exemplary embodiment of the write-acknowledge circuit 40 which comprises a write detector 2 having two transistors 23 and 24 and inverters 41 and 42, and a bistable element 3 having two NOR gates 13 and 14. The two p-MOS transistors 23 and 24 are connected to one another in accordance with the n-MOS transistors 21 and 22, the ends of the transistors forming the write inputs 4 and 5 and acknowledge output 6. The bistable element 3 having two NOR gates 13 and 14 is represented in accordance with Fig. 1. The NOR gates 13 and 14 are connected to the control inputs of the p-MOS transistors 24 and 23 respectively via the outputs 7 and 8 and inverters 42 and 41. The inputs of inverters 41 and 42 form the complementary inputs of write detector 2.

In the respective write-acknowledge circuits 50 and 60 shown in Figs. 5 and 6 two NAND gates 19 and 20 in the bistable element 3 are used. In Fig. 5 the two p-MOS transistors 23 and 24 form the write detector 2, while the control inputs of transistors 23 and 24 are connected to the outputs 8 and 7 respectively. Alternatively, in Fig. 6 two n-MOS transistors 21 and 22 are used whose control inputs are connected to the respective outputs 8 and 7 via inverters 61 and 62.

The exemplary embodiments of the write-acknowledge circuits 50 and 60 in Figs. 5 and 6 are used in the situation in which with Double-Rail Encoding the state at which the two write signals w0 and w1 are simultaneously low is prohibited and in the state of rest the two write signals w0 and w1 are simultaneously high.

In the Figs. 4 and 6 the control inputs of the p-MOS transistors 23, 24 and the n-MOS transistors 21, 22 respectively, may also be directly connected to outputs 7 and 8 of the respective NOR gates 13 and 14 and not via inverters 41, 42 or 61, 62 respectively, to the second input of either NOR gate. However, such an arrangement of the acknowledge circuit is disadvantageous in that when the signal value on one of the write inputs 4 or 5 changes, both transistors will be conductive during this transition period which causes undesired dissipation and impurities in the relevant input signals.

The two transistors in write detector 2 may naturally also be bipolar transistors whereby n-MOS transistors are replaced by npn transistors and p-MOS transistors by pnp transistors.

## Claims

1. Write-acknowledge circuit comprising a write detector (2) having two write inputs (4,5), two complementary inputs and an acknowledge output (6) and including a bistable element (3) having two inputs which form the two respective write inputs (4,5) of the write detector (2) and having two outputs (7,8) coupled crosswise to the complementary inputs of the write detector (2) for applying two couplementary signals to the two couplementary inputs of the write detector in response to a write signal on one of the two write inputs (4,5), characterized in that the write detector (2) comprises a series connection of two switch elements (21,22;23,24) in which each switch element has a first terminal, a second terminal and a control input, which first terminals form the two write inputs (4,5) of the write detector (2), which second terminals are interconnected and collectively form the acknowledge output (6) and in which the control inputs form the two complementary inputs of the write detector (2).

2. Write-acknowledge circuit as claimed in Claim 1,
characterized in that each switch element comprises either an n-MOS transistor (21,22) having a control input which forms the control input of the switch element or comprises a p-MOS transistor (23,24) with an inverter (41,42) where the inverter input forms the control input of the switch element and the inverter output is connected to a control input of the p-MOS transistor (23,24), and in that the bistable element (3) comprises two NOR gates (13,14) having each two inputs and a single output which form the inputs and the outputs (7,8) of the bistable element.

3. Write-acknowledge circuit as claimed in Claim 1,
characterized in that each switch element comprises either a p-MOS transistor (23,24) having a control input which forms the control input of the switch element or comprises an n-MOS transistor (21,22) with an inverter (61,62) where the inverter input forms the control input of the switch element and the inverter output is connected to a control input of the n-MOS transistor (21,22), and in that the bistable element (3) comprises two NAND gates (19,20) having each two inputs and an output which form the inputs and the outputs (7,8) of the bistable element.

## Patentansprüche

1. Schreib-Quittierschaltung mit einem Schreibdetektor (2), der zwei Schreibeingänge (4, 5), zwei komplementäre Eingänge und einen Quittierausgang (6) umfaßt und ein bistabiles Element (3) mit zwei Eingängen enthält, die die beiden jeweiligen Schreibeingänge (4, 5) des Schreibdetektors (2) bilden, und mit zwei kreuzweise mit den komplementären Eingängen des Schreibdetektors (2) gekoppelten Ausgängen, um an die beiden komplementären Eingänge des Schreibdetektors in Reaktion auf ein Schreibsignal auf einem der beiden Schreibeingänge (4, 5) zwei komplementäre Signale zu legen, dadurch gekennzeichnet, daß der Schreibdetektor (2) eine Reihenschaltung aus zwei Schaltelementen (21, 22; 23, 24) umfaßt, in der jedes Schaltelement einen ersten Anschluß, einen zweiten Anschluß und einen Steuereingang hat, welche ersten Anschlüsse die beiden Schreibeingänge (4, 5) des Schreibdetektors (2) bilden, welche zweiten Anschlüsse miteinander verbunden sind und zusammen den Quittierausgang (6) bilden und wobei die Steuereingänge die beiden komplementären Eingänge des Schreibdetektors (2) bilden.

2. Schreib-Quittierschaltung nach Anspruch 1, dadurch gekennzeichnet, daß jedes Schaltelement entweder einen NMOS-Transistor (21, 22) mit einem Steuereingang umfaßt, der den Steuereingang des Schaltelements bildet, oder einen PMOS-Transistor (23, 24) mit einem Inverter (41, 42), wobei der Invertereingang den Steuereingang des Schaltelements bildet und der Inverterausgang mit einem Steuereingang des PMOS-Transistors (23, 24) verbunden ist, und daß das bistabile Element (3) zwei NOR-Gatter (13, 14) mit jeweils zwei Eingängen und einem einzigen Ausgang umfaßt, die die Eingänge und die Ausgänge (7, 8) des bistabilen Elements bilden.

3. Schreib-Quittierschaltung nach Anspruch 1, dadurch gekennzeichnet, daß jedes Schaltelement entweder einen PMOS-Transistor (23, 24) mit einem Steuereingang umfaßt, der den Steuereingang des Schaltelements bildet, oder einen NMOS-Transistor (21, 22) mit einem Inverter (61,62), wobei der Invertereingang den Steuereingang des Schaltelements bildet und der Inverterausgang mit einem Steuereingang des NMOS-Transistors (21, 22) verbunden ist, und daß das bistabile Element (3) zwei NAND-Gatter (19, 20) mit jeweils zwei Eingängen und einem einzigen Ausgang umfaßt, die die Eingänge und die Ausgänge (7, 8) des bistabilen Elements bilden.

## Revendications

1. Circuit de reconnaissance d'écriture comprenant un détecteur d'écriture (2) ayant deux entrées d'écriture (4, 5), deux entrées complémentaires et une sortie de reconnaissance (6), et comprenant un élément bistable (3) ayant deux entrées qui forment les deux entrées d'écriture respectives (4, 5) du détecteur d'écriture (2), et ayant deux sorties (7, 8) couplées en croix aux entrées complémentaires du détecteur d'écriture (2) pour appliquer deux signaux complémentaires aux deux entrées complémentaires du détecteur d'écriture en réaction à un signal d'écriture appliqué sur l'une des deux entrées d'écriture (4, 5), caractérisé en ce que le détecteur d'écriture (2) comprend un montage en série de deux éléments de commutation (21, 22; 23, 24) dans lequel chaque élément de commutation comporte une première borne, une deuxième borne et une entrée de commande, lesdites premières bornes formant les deux entrées d'écriture (4, 5) du détecteur d'écriture (2), lesdites deuxièmes bornes étant interconnectées et formant collectivement la sortie de reconnaissance (6), et dans lequel les entrées de commande forment les deux entrées complémentaires du détecteur d'écriture (2).

2. Circuit de reconnaissance d'écriture selon la revendication 1, caractérisé en ce que chaque élément de commutation comprend soit un transistor n-MOS (21, 22) ayant une entrée de commande qui constitue l'entrée de commande de l'élément de commutation, soit un transistor p-MOS (23, 24) avec un inverseur (41, 42), l'entrée de l'inverseur constituant l'entrée de commande de l'élément de commutation et la sortie de l'inverseur étant connectée à une entrée de commande du transistor p-MOS (23, 24), et en ce que l'élément bistable (3) comprend deux portes NON-OU (13, 14) ayant chacune deux entrées et une seule sortie qui forment les entrées et les sorties (7, 8) de l'élément bistable.

3. Circuit de reconnaissance d'écriture selon la revendication 1, caractérisé en ce que chaque élément de commutation comprend soit un transistor p-MOS (23, 24) ayant une entrée de commande qui constitue l'entrée de commande de l'élément de commutation, soit un transistor n-MOS (21, 22) avec un inverseur (61, 62), l'entrée de l'inverseur constituant l'entrée de commande de l'élément de commutation, et la sortie de l'inverseur étant connectée à une entrée de commande du transistor n-MOS (21, 22), et en ce que l'élément bistable (3) comprend deux portes NON-ET (19, 20) ayant chacune deux entrées et une sortie qui constituent les entrées et les sorties (7, 8) de l'élément bistable.
